# EUROPEAN PATENT APPLICATION

(11) **EP 3 467 595 A1**
(43) Date of publication of application: **10.04.2019**
(21) Application number: 17802607.6
(22) Date of filing: 15.05.2017
(51) Int. Cl.: G03H 1/04, G03H 1/02, H01S 5/062, H01S 5/065, G03H 1/00, G03H 1/06, G02F 1/35

(54) **HOLOGRAPHIC OBSERVATION METHOD AND DEVICE**

(30) Priority: 27.05.2016 WO PCT/JP2016/065835
(71) Applicant: Shimadzu Corporation, Kyoto-shi, Kyoto 6048511 (JP)
(72) Inventor: KONDO, Yasushi, Kyoto-shi Kyoto 604-8511 (JP); ARAKI, Takahisa, Kyoto-shi Kyoto 604-8511 (JP); UNO, Shingo, Kyoto-shi Kyoto 604-8511 (JP)
(74) Representative: Mewburn Ellis LLP
(86) International application number: PCT/JP2017/018175
(87) International publication number: WO 2017/204013

(57) **Abstract**

A holographic observation method includes: casting a light beam generated by driving a semiconductor laser light source with an electric current with an alternating-current component superimposed or a light beam having a predetermined spectral width and predetermined spectral intensity to have predetermined coherency to an observation object; forming a hologram by causing a light beam transmitted through or reflected by the observation object to interfere with a reference light beam; and obtaining information on the observation object by performing image processing on the hologram. For example, an in-line holographic observation device 1 is used. The holographic observation device 1 includes a light source 2 that emits a light beam having a predetermined spectral width and predetermined spectral intensity to have predetermined coherency; an exposure optical system 2 that splits the light beam into two light beams, and causes the both light beams to be transmitted through or reflected by the observation object; and an image sensor 4 that acquires an interference image of the light beams transmitted through or reflected by the observation object.

## Description

### TECHNICAL FIELD

The present invention relates to a method and a device that use holography to observe a target object.

### BACKGROUND ART

With the progress of regenerative medical technology and the like that use iPS cells, there are demands for a device to culture and observe iPS cells or other cells and properly control the differentiation state, etc. of the cells. Such a device needs to acquire images of the cells in the course of culture and make various measurements and analyses on the basis of the image data. As a device that observes cells, there is a device to make the observation using a phase-contrast microscope; however, the area the device can photograph in one shooting is limited, and therefore, to observe the entirety, an entire observation needs to be made while changing a photographing spot by a step-and-repeat method. Then, it is necessary to focus on an object with each shift of the photographing spot, which leads to a problem that it takes time to photograph the entirety. In an observation of cultured cells, photographing needs to be finished in as short a time as possible not to cause damage to the cells.

Accordingly, a holographic observation device that uses holography to photograph cells has been widely used. A holographic image (a hologram) is obtained as follows: a light beam in phase (a coherent light beam) is split into two light beams; one of the two light beams is cast on a target object, and is transmitted through or reflected by the target object; the other light beam travels as it is; and the two light beams interfere with each other on an image plane. The hologram obtained in this way includes information of a three-dimensional shape, optical composition, etc. of the target object, and these pieces of information can be extracted by performing various operations on the hologram. On the basis of three-dimensional data of the target object obtained at the time of photographing, two-dimensional image data in the vicinity of a focused point can be obtained when an image is reconstructed, that is, it is not necessary to perform focusing at the time of photographing. This brings about an advantage that it is possible to make an entire observation faster as compared with the case of using the above-described phase-contrast microscope. The term "light beam" in this specification means light having a two-dimensionally spread cross-section.

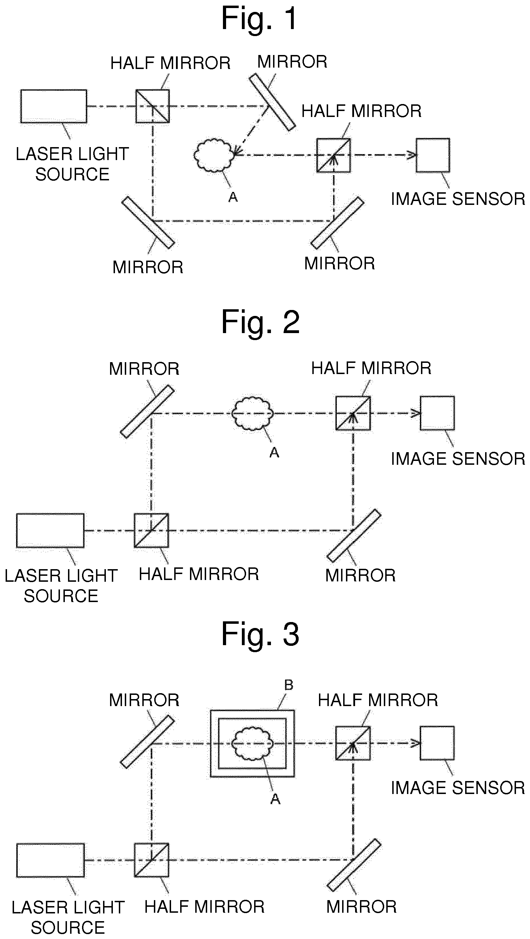

There are two types of holographic observation devices: one that uses a light beam reflected by an observation object A as illustrated in Fig. 1 and one that uses a light beam transmitted through the observation object A as illustrated in Fig. 2 (Non Patent Literature 2). In either type of holographic observation devices, a coherent light beam from a light source undergoes a phase shift according to the optical structure of the observation object A when the coherent light beam is reflected by or transmitted through the observation object A. A hologram is obtained by causing a light beam that has undergone a phase shift in this way to interfere with a reference light beam that has not undergone such a phase shift on an image sensor.

### CITATION LIST

### PATENT LITERATURE

Patent Literature 1: JP 2013-92603 A
Patent Literature 2: JP 2000-216485 A

### NON PATENT LITERATURE

Non Patent Literature 1: R. Stahl, et al., "Lens-free digital in-line holographic imaging for wide field-of-view, high resolution and real-time monitoring of complex microscopic objects", Proc. of SPIE Vol. 8947

Non Patent Literature 2: Yasuhiro Awatsuji, "Development of a method and device for three-dimensional dynamic image measurement of cells with parallel digital holographic microscopy", HORIBA, Ltd. Readout (35), 10-15, 2009-12 (2009)

### SUMMARY OF INVENTION

### TECHNICAL PROBLEM

As schematically illustrated in Fig. 3, besides an observation object, various objects are present on a light path where an observation is made. For example, in a case of observing living cells, the observation is made with the cells suspended in a culture medium in a container or set on a glass plate; in this case, besides the cells that are the objects of observation, the container or the glass plate, etc. are present on the light path. A phase shift of a coherent light beam is caused by not only the observation object but also other objects on the light path. If interference due to a phase shift caused by a non-observation object B (such as the container in the previous example) in Fig. 3 affects an interference image generated by an originally needed phase shift caused by an observation object A (the cells), an image noise is generated, which deteriorates the image quality of a hologram of the observation object A. Accordingly, to obtain an excellent observation image, it is desirable to eliminate as much influence of a phase shift caused by an object (a non-observation object) other than an observation object as possible and detect only an interference image generated by a phase shift caused by the observation object.

The problem to be solved by the present invention is to provide a holographic observation method and device capable of obtaining as high-resolution a hologram of only an observation object as possible while suppressing the influence of a phase shift caused by object(s) other than the observation object.

### SOLUTION TO PROBLEM

A holographic observation method according to the present invention developed for solving the above-described problem includes: casting a light beam generated by driving a semiconductor laser light source with an electric current with an alternating-current component superimposed or a light beam having a predetermined spectral width and predetermined spectral intensity to have predetermined coherency to an observation object; forming a hologram by causing the light beam transmitted through or reflected by the observation object to interfere with a reference light beam; and obtaining information on the observation object by performing image processing on the hologram.

When the semiconductor laser light source is driven with the electric current with the alternating-current component superimposed, a light beam that has a spectral width depending on the amplitude and frequency of the superimposed alternating-current component and has lower coherency than a semiconductor laser beam generated by driving the semiconductor laser light source with an invariable constant direct current is obtained. Furthermore, a light beam that has a predetermined spectral width and predetermined spectral intensity and lower coherency than a semiconductor laser beam generated by driving the semiconductor laser light source with a direct current is also obtained from a superluminescent diode (SLD) light source. The above-described light beam having a predetermined spectral width and predetermined spectral intensity to have predetermined coherency means a light beam emitted from such a light source, such as an SLD light source. In a case where a hologram is formed by using a coherent light beam with a small spectral width (i.e., of a single wavelength) generated from a semiconductor laser light source driven with a direct current, the coherency is maintained even if it is distant from the light source that emits the coherent light beam; therefore, interference with the reference light beam can occur over a long distance (that is, the coherence length is long). Therefore, a result of a phase shift caused by not only an observation object but also non-observation objects (for example, in a case of observing cells, a container that contains the cells, the lid of the container, other optical components, etc.) is also included in the hologram. On the other hand, in a light beam having a predetermined spectral width and predetermined spectral intensity to have predetermined coherency used in the present invention, the lower the coherency, the shorter the coherence length. Accordingly, it is possible to involve (include) only the result of a phase shift caused by the observation object in the hologram and not to involve (not to include) the result of a phase shift caused by a non-observation object other than the observation object in the hologram. In this specification, such light having a predetermined spectral width and predetermined spectral intensity to have predetermined coherency is referred to as pseudo-coherent light. Pseudo-coherent light used in the present invention may also be referred to as low-coherent light in contrast with high-coherent light, such as semiconductor laser light.

Appropriate values of the above-described predetermined spectral width and predetermined spectral intensity depend on the size and optical characteristics of an observation object; these values can be easily determined by performing experiments in advance. An example will be described later.

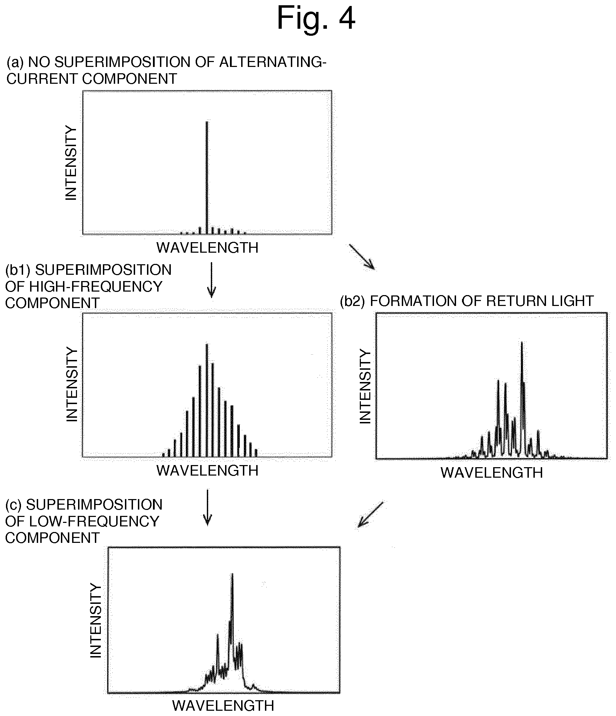

As described above, one of methods to form a light beam used in the present invention (a pseudo-coherent light beam) is a method of using a semiconductor laser diode (a semiconductor laser) as the semiconductor laser light source and superimposing an alternating-current signal on a current source that drives the semiconductor laser diode. In a case of a single-mode laser, the semiconductor laser diode is basically driven with a constant direct current; however, in that case, a light beam having a very narrow spectral width and high coherency is obtained (an emission spectrum (a) illustrated in Fig. 4). On the other hand, if an alternating current is superimposed on the drive direct current, a generated spectrum of the light beam becomes wide under a certain condition.

The mode of this spectrum is different according to the frequency of the superimposed alternating-current component. For example, in a case where the frequency of the superimposed alternating-current component is a high frequency of about 100 MHz to 500 MHz, the spectrum becomes discretely spread as an emission spectrum (b1) illustrated in Fig. 4 (Patent Literatures 1 and 2). The reason why such spread of the spectrum is formed is considered as follows. That is, even in a case where the semiconductor laser diode that is a single-mode laser is driven with a constant direct current as usual, center-mode emission and positive and negative primary and secondary side-mode emissions are generated (i.e., a multimode emission state is formed), and as a result, emission has a spectral distribution discretely spread as the emission spectrum (b1) illustrated in Fig. 4. However, if the semiconductor laser diode is kept being driven with constant direct-current power, the side modes are soon attenuated, and only emission in the center mode only (longitudinal-mode single emission) remains. On the other hand, in a case where the semiconductor laser diode that is such a single-mode laser is driven with an alternating-current component of a high frequency of about 100 MHz to 500 MHz superimposed, the electric current varies before the semiconductor laser diode becomes stable in the state of longitudinal-mode single emission; therefore, the side-mode emissions are maintained, and as a result, emission having a spectral distribution discretely spread as the emission spectrum (b1) illustrated in Fig. 4 is maintained.

On the other hand, in a case where the frequency of the superimposed alternating-current component is a low frequency of about 50 kHz to 300 kHz, it is confirmed that the emission wavelength temporally fluctuates. Such a fluctuation is considered to be caused by the superimposition of the low-frequency alternating-current component, resulting in temporal fluctuations of an electric current, a refractive index of inside a resonator, a temperature distribution, etc. In a case where the frequency of the superimposed alternating-current component is sufficiently higher (preferably, about 1000 times higher) than a readout frequency of the image sensor (i.e., the image sensor that acquires an interference image of the light beam transmitted through or reflected by the observation object), it can be considered that the period of this fluctuation is temporally averaged at the time of photographing and the peak width of a spectrum is increased (a broad spectrum is obtained).

In this way, whichever of a high-frequency alternating-current component and a low-frequency alternating-current component can increase the spectral width by superimposing the alternating-current component. However, as described above, the manner of a spread is different between the high-frequency alternating-current component and the low-frequency alternating-current component; therefore, the spectral width can be effectively increased by a combination of the both. That is, in the semiconductor laser diode that forms emission having a spectral distribution discretely spread as the emission spectrum (b1) illustrated in Fig. 4 by being driven with an electric current with a high-frequency alternating-current component superimposed, when a low-frequency alternating-current component is further superimposed on the drive current, respective peak widths of discretely existing peaks are increased, and as a result, a spectrum becomes continuously spread as an emission spectrum (c) illustrated in Fig. 4. By superimposing both of the high-frequency alternating-current component and the low-frequency alternating-current component in this way, the spectral width can be increased sufficiently.

Here, the method of obtaining a discretely spread spectrum of light beam from the semiconductor laser diode that produces a spectrum as the emission spectrum (a) illustrated in Fig. 4 is not limited to superimposing a high-frequency alternating-current component on a drive current. That is, a discretely spread spectrum of light beam can also be obtained from the semiconductor laser diode by reflecting a portion of a light beam emitted from the semiconductor laser diode by using, for example, an optical component or the like, thereby returning the portion of light to the semiconductor laser diode (i.e., forming return light). In this configuration, a resonant state is formed between the semiconductor laser diode and the optical component (i.e., a resonator is formed not only inside but also outside the semiconductor laser diode). Accordingly, it is considered that the semiconductor laser diode has different oscillating frequencies for its inside and outside, and as a result, multimode oscillation is generated, and a discretely spread spectrum as an emission spectrum (b2) illustrated in Fig. 4 is present.

The return light can be formed, for example, by arranging a reflecting member having a reflecting surface that reflects at least a portion of incident light on an optical axis of a light beam emitted from the semiconductor laser. Here, the amount of return light can be controlled by the angle of the reflecting member (the angle made by the reflecting surface and the optical axis). However, depending on the amount of return light, there is a possibility of affecting the laser resonator gain, loss, current operating point of the semiconductor laser, the Fresnel reflectance of respective end surfaces of the semiconductor laser and an optical fiber, matching to a laser resonator made by the return light, etc.; therefore, the optimal value of return light is preferably determined by adjustment made by a combination of the angle of the reflecting member and these affected parameters.

In the semiconductor laser diode that forms emission having a spectral distribution discretely spread as the emission spectrum (b2) illustrated in Fig. 4 by the formation of the return light, when a low-frequency alternating-current component is superimposed on its drive current, respective peak widths of discretely existing peaks are increased, and as a result, a spectrum becomes continuously spread as the emission spectrum (c) illustrated in Fig. 4. According to this configuration, the spectral width can be increased sufficiently without superimposition of a high-frequency alternating-current component; therefore, neither a complex circuit configuration nor an expensive component for obtaining a high-frequency alternating-current component is required.

As described above, the above-described light beam (pseudo-coherent light beam) having a predetermined spectral width and predetermined spectral intensity to have predetermined coherency is obtained by driving the semiconductor laser light source with an electric current with an alternating-current component superimposed; however, by appropriately selecting a frequency of the superimposed alternating-current component, the spectral width of the pseudo-coherent light beam can be increased sufficiently. Furthermore, also by increasing the amplitude of the superimposed alternating-current component, the spectral width of the pseudo-coherent light beam can be increased sufficiently. When the spectral width is increased, the coherency is reduced, and the coherence length is shortened. Therefore, the frequency and amplitude of a superimposed alternating-current signal are appropriately changed according to respective sizes (thicknesses) and optical characteristics (for example, refractive indexes) of an observation object and a non-observation object located on a light path, thereby the influence of a phase shift caused by a container, etc. can be eliminated, and only a phase shift caused by the observation object can be reflected in a hologram.

Furthermore, as described above, the above-described light beam (pseudo-coherent light beam) having a predetermined spectral width and predetermined spectral intensity to have predetermined coherency can also be obtained by using, for example, a superluminescent diode (SLD). Moreover, some light-emitting diodes (LEDs) having such characteristics can also be used as a light source of the holographic observation device according to the present invention. SLDs and some LEDs have a predetermined spectral width, and emit light having a shorter coherence length than laser light. In general, the spectral width and coherence length of light emitted from an SLD or an LED are fixed, and therefore, it is necessary to select an SLD or LED corresponding to a coherence length determined according to the size and optical characteristics of an observation object; however, light emitted from the light source can be used as it is without having to superimpose an alternating-current signal, and therefore, it is possible to configure the holographic observation device simply and inexpensively.

The method according to the present invention can be applied irrespective of the method of forming holography.

For example, in a case of in-line holography, an aspect of a holographic observation device using the method according to the present invention includes:
a) a semiconductor laser light source;
b) a current source that supplies a drive current with an alternating-current component superimposed to the semiconductor laser light source;
c) an exposure optical system that causes a light beam emitted from the semiconductor laser light source driven with the drive current to be transmitted through or reflected by an observation object and interfere with light transmitted through or reflected at a different spot of the observation object; and
d) an image sensor that acquires an interference image of the light beam transmitted through or reflected by the observation object.

Furthermore, in a case of in-line holography, another aspect of the holographic observation device using the method according to the present invention includes:
a) a light source that emits a light beam having a predetermined spectral width and predetermined spectral intensity to have predetermined coherency;
b) an exposure optical system that causes the light beam to be transmitted through or reflected by an observation object and interfere with light transmitted through or reflected at a different spot of the observation object; and
c) an image sensor that acquires an interference image of the light beam transmitted through or reflected by the observation object.

In a case of off-axis holography, an aspect of the holographic observation device according to the present invention includes:
a) a semiconductor laser light source;
b) a current source that supplies an electric current with an alternating-current component superimposed to the semiconductor laser light source;
c) an exposure optical system that splits a light beam emitted from the semiconductor laser light source driven with the drive current into two light beams, and causes one of the two light beams to be transmitted through or reflected by an observation object; and
c) an image sensor that acquires an interference image of the light beam transmitted through or reflected by the observation object and a light beam that is the other of the two light beams and is neither transmitted through nor reflected by the observation object.

Furthermore, in a case of off-axis holography, another aspect of the holographic observation device according to the present invention includes:
a) a light source that emits a light beam having a predetermined spectral width and predetermined spectral intensity to have predetermined coherency;
b) an exposure optical system that splits the light beam into two light beams, and causes one of the two light beams to be transmitted through or reflected by an observation object; and
c) an image sensor that acquires an interference image of the light beam transmitted through or reflected by the observation object and a light beam that is the other of the two light beams and is neither transmitted through nor reflected by the observation object.

In either type of holographic observation devices, the operation principle is as described above, and, by using a pseudo-coherent light beam having a short coherence length, a hologram in which only a result of a phase shift caused by the observation object is reflected (only information of the observation object is included) and a result of a phase shift caused by an object other than the observation object is not reflected (not included) can be obtained. As described above, as the light source that emits a light beam having a predetermined spectral width and predetermined spectral intensity to have predetermined coherency, for example, a superluminescent diode (SLD) or some light-emitting diodes (LEDs) that emit a light beam having a predetermined spectral width can be used.

Furthermore, the present invention is also intended for a cell image observation device including any of the above-described holographic observation devices and a light source unit used suitably in, for example, the above-described holographic observation devices.

### ADVANTAGEOUS EFFECTS OF THE INVENTION

In the holographic observation method and device according to the present invention, a pseudo-coherent light beam with a short coherence length that has a predetermined spectral width and predetermined spectral intensity to have predetermined coherency is used as an observation light beam. Accordingly, it is possible to reflect (include) only a result of a phase shift caused by an observation object in a hologram and not to reflect (not to include) a result of a phase shift caused by an object other than the observation object in the hologram; therefore, it is possible to eliminate noise due to a non-observation object and obtain a hologram in which the resolution of only the observation object is high.

### BRIEF DESCRIPTION OF DRAWINGS

Fig. 1 is a configuration example of an off-axis holographic observation device using reflected light from an observation object.
Fig. 2 is a configuration example of an off-axis holographic observation device using transmitted light from an observation object.
Fig. 3 is a diagram illustrating a problem in a conventional holographic observation device.
Fig. 4 illustrates an emission spectrum (a) in a case where a semiconductor laser light source is driven with a direct current, an emission spectrum (b1) in a case where a high-frequency alternating-current signal is superimposed on a drive current of the semiconductor laser light source, an emission spectrum (b2) in a case where return light to the semiconductor laser light source is formed, and an emission spectrum (c) in a case where a low-frequency alternating-current signal is superimposed on the drive current of the semiconductor laser light source.
Fig. 5 is a configuration diagram of a main part of an in-line holographic observation device that is an embodiment of a holographic observation device according to the present invention.
Fig. 6 is a configuration diagram of a light source unit of the holographic observation device according to the present embodiment.
Figs. 7(a), 7(b) and 7(c) are diagrams each illustrating a change in a coherence length of a coherent light beam in a case where an alternating-current signal is superimposed on a drive current.
Figs. 8(a) and 8(b) are diagrams each illustrating an observation image obtained by the holographic observation device according to the present invention.
Fig. 9 is a configuration diagram of a light source unit used in a modification example of the holographic observation device according to the present invention.
Fig. 10 is a configuration diagram of a main part of an off-axis holographic observation device that is a modification example of the holographic observation device according to the present invention.
Fig. 11 is a configuration diagram of a light source unit used in another modification example of the holographic observation device according to the present invention.

### DESCRIPTION OF EMBODIMENTS

An embodiment of a holographic observation method and device according to the present invention is described with reference to the drawings. The holographic observation device in the present embodiment is a so-called in-line holographic observation device (see Non Patent Literatures 1 and 2 regarding an in-line holographic observation device), and is used to acquire an observation image of cells, such as iPS cells or ES cells, cultured on a culture plate.

### <1. Device configuration>

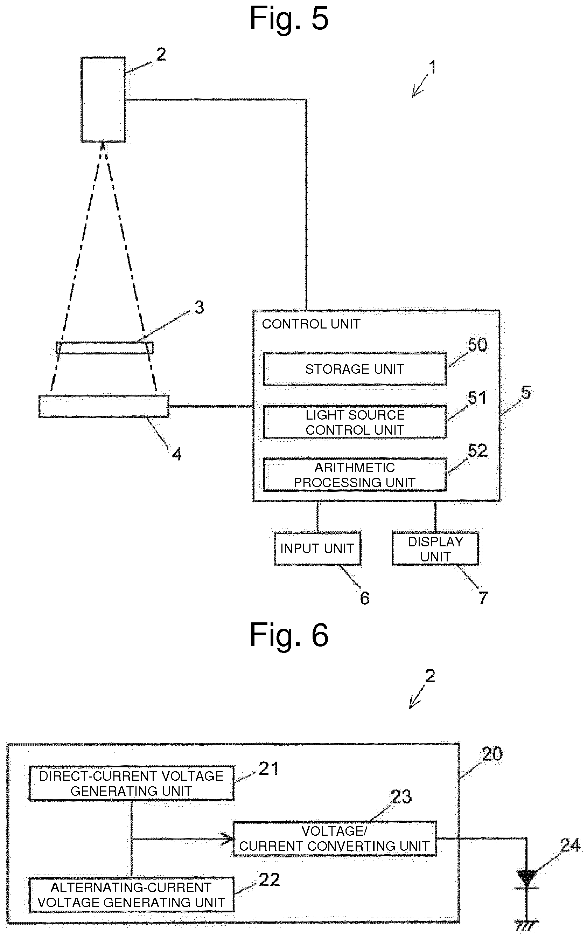

Fig. 5 illustrates a configuration of a main part of the holographic observation device in the present embodiment. A holographic observation device 1 includes a light source unit 2, an image sensor 4, and a control unit 5. Cells on a culture plate 3 are exposed to a pseudo-coherent light beam with a minute spread angle (about 10 degrees) emitted from the light source unit 2. Of the pseudo-coherent light beam, a portion transmitted through the cells and the culture plate 3 reaches the image sensor 4 while interfering with a portion transmitted through a spot adjacent to the cells on the culture plate 3. Although not illustrated in Fig. 5, an appropriate exposure optical system is used to cause a spot size of a light beam emitted from the light source unit 2 to be big enough for the whole cells to be exposed to the light beam.

The control unit 5 includes a storage unit 50, and further includes, as a functional block, a light source control unit 51 and an arithmetic processing unit 52. The light source control unit 51 controls the operation of the light source unit 2. The arithmetic processing unit 52 includes an arithmetic processing unit 52 that finds phase information from hologram data (two-dimensional intensity distribution data of a pseudo-coherent light beam formed on a detection surface of the image sensor 4) acquired by the image sensor 4 by an arithmetic operation, and creates an observation image of the cells. In the storage unit 50, pseudo-coherent light beam characteristics information is stored in advance; the pseudo-coherent light beam characteristics information is information on a relationship between the magnitude of an electric current supplied to a semiconductor laser diode 24 and the intensity of a pseudo-coherent light beam and a relationship between the amplitude and frequency of an alternating-current signal and the coherence length of the pseudo-coherent light beam. The relationship between the amplitude and frequency of the alternating-current signal and the coherence length of the pseudo-coherent light beam will be described later. Furthermore, an input unit 6 and a display unit 7 are connected to the control unit 5. The observation image created by the arithmetic processing unit 52 is displayed on the display unit 7.

As illustrated in Fig. 6, the light source unit 2 includes the semiconductor laser diode 24 and a drive current supply unit 20 that supplies a drive current to the semiconductor laser diode 24. Furthermore, the drive current supply unit 20 includes a direct-current voltage generating unit 21 that generates a direct-current voltage, an alternating-current voltage generating unit 22 that generates an alternating-current voltage and superimposes the alternating-current voltage on the direct-current voltage, and a voltage/current converting unit 23. On the basis of a user's input instruction on the intensity and coherence length of a pseudo-coherent light beam and the pseudo-coherent light beam characteristics information stored in the storage unit 50, the light source control unit 51 determines the magnitude of a direct-current voltage to be generated by the direct-current voltage generating unit 21 and adjusts the intensity of a semiconductor laser beam, or determines values of the amplitude and frequency of an alternating-current voltage to be generated by the alternating-current voltage generating unit 22 and adjusts the coherence length of the semiconductor laser beam.

### <2. Amplitude and frequency of alternating-current signal>

As described above, the holographic observation device 1 in the present embodiment observes cells on the culture plate 3. When a user inputs values of an estimated thickness (generally, about tens of micrometers to 100 µm) of the cells and a thickness (generally, about 1 mm) of the culture plate 3, the light source control unit 51 determines the amplitude and frequency of an alternating-current signal so that the coherence length of a pseudo-coherent light beam generated is longer than the thickness (for example, tens of micrometers to 100 µm) of an observation object (the cells) and shorter than the thickness (for example, about 1 mm) of a non-observation object (the culture plate 3) present on a light path on the basis of the pseudo-coherent light beam characteristics information. However, this frequency is set to be a frequency sufficiently higher than a signal readout period of the image sensor 4 (for example, a frequency that is 1000 times higher than a signal readout frequency of the image sensor 4). In the present embodiment, a non-observation object present on the light path is only the culture plate 3, thus the thickness of the culture plate 3 is input; however, in a case where a container in which a sample is contained, a glass plate, etc. are present on the light path, the user inputs the thicknesses of these as well. Alternatively, the user inputs the thickness of the thinnest one of non-observation objects. Here, it is configured to input only the thicknesses of the cells and the culture plate 3; however, in a case where an observation object, etc. are thick, the optical path length varies greatly depending on the refractive index, and therefore, it is preferable to input a refractive index as well as a thickness and configure the coherence length of a pseudo-coherent light beam to be longer than an optical thickness (the product of a physical thickness and a refractive index) of the observation object and shorter than an optical thickness of a non-observation object.

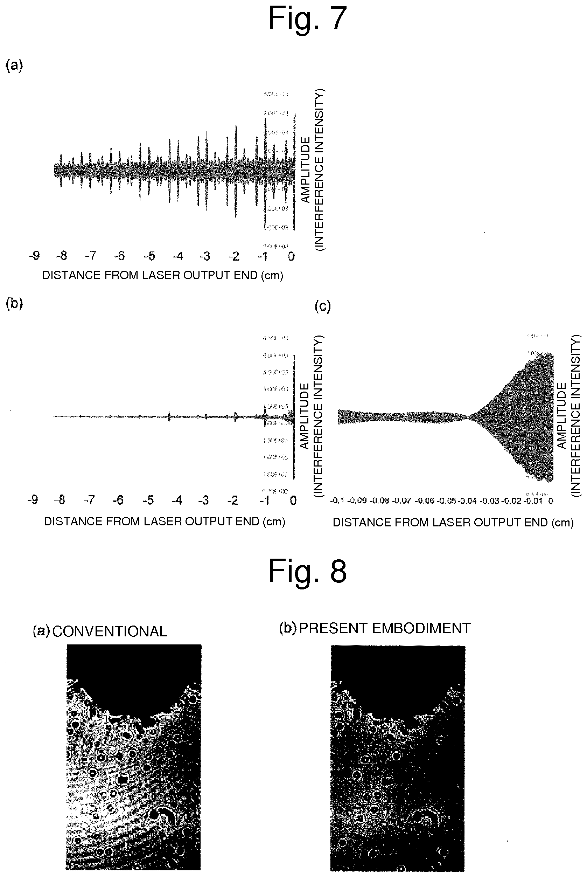

Here, a relationship between the amplitude of an alternating-current signal and the coherence length of a pseudo-coherent light beam is described. As a semiconductor laser diode, a single-mode laser (LP642-SF20) available from THORLABS, Inc. was used. Fig. 7(a) is a measurement result illustrating the coherence length when the semiconductor laser diode was driven with a direct current only. The horizontal axis of a graph indicates a distance from an output end of semiconductor laser light that increases toward the left side, and the vertical axis indicates an amplitude (interference intensity) at the distance. In this measurement, the amplitude was measured only up to a distance of about 8 cm from the output end of semiconductor laser light; however, sufficiently large interference peaks can be seen at up to this distance, and therefore, the coherence length is considered to be about a few meters.

Fig. 7(b) is a graph illustrating the coherence length when an alternating-current signal (a frequency of 100 kHz, an amplitude of 30% with respect to a direct current) was superimposed on a drive current of the semiconductor laser diode; Fig. 7(c) is an enlarged graph at near the output end of semiconductor laser light. In Fig. 7(b), the coherence length was reduced to about 4 mm from the output end of semiconductor laser light, and the interference intensity was significantly decreased, and most of peaks associated with interference vanished. Furthermore, as a result of the inventors' measurement of the coherence length while changing the amplitude of an alternating-current signal, it was confirmed that the larger the amplitude of an alternating-current signal superimposed on a drive current of the semiconductor laser diode, the shorter the coherence length of a semiconductor laser beam. This is thought to be because the larger the amplitude of an alternating-current signal superimposed, the wider the spectral width of a light beam, and as a result, the coherency is reduced, and the coherence length is shortened.

Further, a relationship between the frequency of an alternating-current signal and the coherence length of a pseudo-coherent light beam is described. Also, here, a single-mode laser (LP642-SF20) available from THORLABS, Inc. was used as a semiconductor laser diode. Because of the specific characteristics of the semiconductor laser diode, this semiconductor laser diode produced a discretely spread spectral distribution as an emission spectrum (b1) illustrated in Fig. 4 even when driven with a direct current only, and an emission spectrum (c) illustrated in Fig. 4 was obtained by superimposing an alternating-current signal with a frequency of 100 kHz on a drive current of this semiconductor laser diode. As described above, it is considered that by superimposing an alternating-current signal of a low frequency of about 50 kHz to 300 kHz, an oscillation spectrum is broadened, and the spectral width is increased. The increase in the spectral width reduces the coherency, and the coherence length is shortened.

However, as described above, the frequency of an alternating-current signal superimposed on the drive current is preferably a frequency that can modulate semiconductor laser light with a period sufficiently shorter than a signal readout period of the image sensor 4 (i.e., a frequency sufficiently higher than a signal readout frequency of the image sensor 4), and is particularly preferably about 1000 times higher than the signal readout frequency of the image sensor 4. For example, in a case of the above-described general image sensor, a signal readout period is 33 ms (a signal readout frequency is 30 Hz); therefore, the above-described alternating-current signal of a low frequency of 50 kHz to 300 kHz can be used sufficiently suitably.

A laser beam (a pseudo-coherent light beam) with an intended coherence length can be obtained by generating an alternating-current voltage with the appropriate amplitude and frequency by taking the thickness (and the refractive index) of an observation object and a non-observation object located on a light path into consideration and driving the semiconductor laser diode 24 with the alternating-current voltage superimposed on a direct-current voltage.

### <3. Comparison of observation images>

As a conventional holographic observation device uses a coherent light beam with a coherence length of a few meters or more, interference fringes caused by a phase shift due to the culture plate 3 are superimposed on an observation image of cells, and this deteriorates the image quality. Fig. 8(a) is an observation image of only the culture plate 3 (no culture medium nor cells) that was acquired by exposing the culture plate 3 to a coherent light beam of 642 nm by a conventional holographic observation method (device). This observation image illustrates that unwanted interference fringes caused by a phase shift of the culture plate 3 are superimposed on over the entire image.

Fig. 8(b) is an observation image of only the culture plate 3 (no culture medium nor cells) that was acquired by driving the above-described semiconductor laser diode with an alternating-current voltage of a frequency of 100 kHz and an amplitude (an amplitude with respect to a drive direct current) of 24% superimposed on a direct-current voltage and exposing the culture plate 3 to a pseudo-coherent light beam with a spectrum center of 642 nm in the holographic observation method (device) in the present embodiment. In both Figs. 8(a) and 8(b), an image sensor with a readout period of 33 ms (a readout frequency of 30 Hz) was used. It can be seen that in the observation image of Fig. 8(b), unwanted interference fringes caused by the culture plate 3 are significantly reduced.

### <4. Modification examples>

The above-described embodiment is merely an example, and can be appropriately modified in accordance with the gist of the present invention.

### <4-1. Modification example of frequency of alternating-current component>

In the above-described embodiment, a frequency of an alternating-current component superimposed on a drive current (specifically, a frequency of an alternating-current voltage superimposed on a direct-current voltage) is not limited to a low frequency of 50 kHz to 300 kHz. For example, an alternating-current component of a high frequency of 1 MHz to hundreds of megahertz (preferably, 100 MHz to 500 MHz) may be superimposed, or both of these low- and high-frequency components may be superimposed.

A general semiconductor laser diode that oscillates in single mode typically produces a type of an emission spectrum (a) illustrated in Fig. 4 when driven with a drive current. When such a semiconductor laser diode is driven with an electric current on which an alternating-current component of a high frequency of 100 MHz to 500 MHz is superimposed, the emission spectrum of the semiconductor laser diode is as the emission spectrum (b1) illustrated in Fig. 4. That is, by superimposing an alternating-current component of a high frequency of 100 MHz to 500 MHz, the emission spectrum becomes discretely spread.

In the semiconductor laser diode that forms emission of such a discretely spread spectral distribution, when an alternating-current component of a low frequency of about 50 kHz to 300 kHz is further superimposed (i.e., an alternating-current component that a high-frequency component of 100 MHz to 500 MHz and a low-frequency component of 50 kHz to 300 kHz are superimposed on each other is superimposed) on the drive current, respective peak widths of discretely existing peaks are increased, and the emission spectrum becomes continuously spread as the emission spectrum (c) illustrated in Fig. 4. By superimposing an alternating-current component that a high-frequency component and a low-frequency component are superimposed on each other is superimposed on a drive current in this way, the spectral width can be increased sufficiently.

In this way, the spectral width can be increased by superimposing either one (or both) of a high-frequency alternating-current component and a low-frequency alternating-current component, and an intended coherence length can be obtained by selecting the frequency appropriately. Accordingly, an observation image in which superimposition of unwanted interference fringes is reduced can be obtained.

### <4-2. Alternative method of superimposition of high-frequency component>

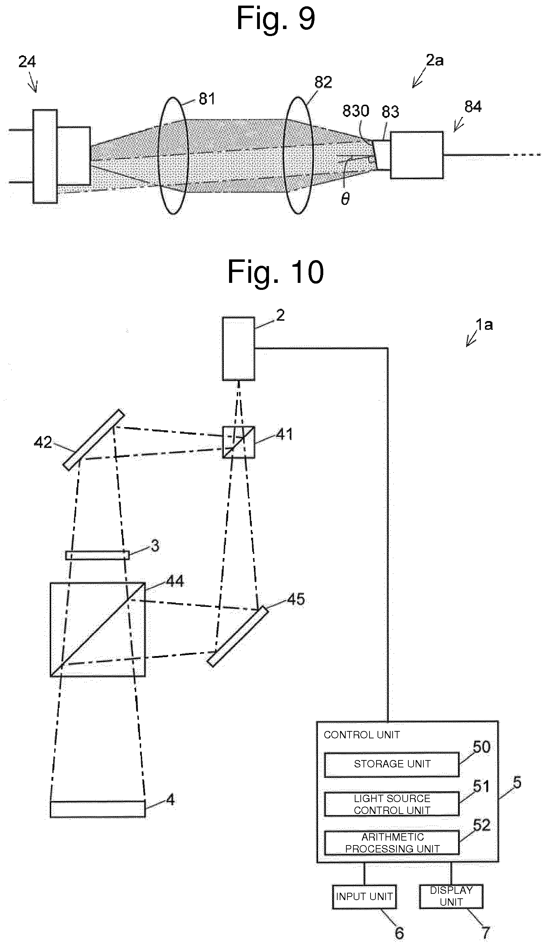

One of methods to obtain a discretely spread spectrum of light beam from the semiconductor laser diode that produces the type of the emission spectrum (a) illustrated in Fig. 4 is, as described above, superimposing a high-frequency alternating-current component on a drive current; however, there is another method. Fig. 9 illustrates a configuration example of a light source unit 2a according to another method. In this light source unit 2a, light emitted from the semiconductor laser diode 24 is collimated to parallel light by a collimating lens 81, and is concentrated to a ferrule 83 by a focusing lens 82, and is led by an optical fiber 84, and then is emitted to cells on the culture plate 3 (see Fig. 5). The ferrule 83 here has a distal end which is formed of a reflecting surface 830 that reflects a portion of incident light, and the reflecting surface 830 is arranged on an optical axis of the light beam emitted from the semiconductor laser diode 24. Furthermore, the reflecting surface 830 is arranged in an orientation that allows the normal line of the reflecting surface 830 and the optical axis to make a predetermined angle θ that is not 0. That is, the reflecting surface 830 is arranged in an orientation that allows the normal line of the reflecting surface 830 to be inconsistent with the optical axis.

The predetermined angle θ here is an angle that allows a portion of a light beam reflected by the reflecting surface 830 to return to the semiconductor laser diode 24 (i.e., allows return light to be formed). The smaller the angle θ, the more the light returns to the semiconductor laser diode 24; however, if too much light returns to the semiconductor laser diode 24, the semiconductor laser diode 24 may be damaged by the return light. On the other hand, the larger the angle θ, the less the light returns to the semiconductor laser diode 24; if the angle θ exceeds a certain angle, no light returns to the semiconductor laser diode 24. As an example, by limiting the angle θ to be in a range of more than 0° but not exceeding 7°, 10% to 90% of the light emitted from the semiconductor laser diode 24 is allowed to return to the semiconductor laser diode 24.

However, depending on the amount of light returning to the semiconductor laser diode 24, there is a possibility of affecting parameters of the laser resonator gain, loss, current operating point of the semiconductor laser diode 24, the Fresnel reflectance of respective end surfaces of the semiconductor laser diode 24 and the optical fiber 84, matching to a laser resonator formed of return light, etc.; therefore, the optimal value of return light is preferably determined by adjustment made by a combination of the above-described angle θ and the affected parameters described above.

Specifically, for example, it is preferable that first, rough adjustments of the laser resonator gain and matching impedance of the semiconductor laser diode 24, the amount of drive current, the Fresnel reflectance of respective end surfaces of the semiconductor laser diode 24 and the optical fiber 84, etc. be made in advance so that the operating point of the semiconductor laser diode 24 is optimized, and then fine adjustments of the angle θ, etc. be made so that the optimal (or acceptable) amount of return light is formed and the above-described parameters have an optimal (or acceptable) value.

The reflecting surface 830 for forming return light does not necessarily have to be configured at the distal end of the ferrule 83; alternatively, apart from the ferrule 83, an optical component such as a mirror may be provided so that return light is formed by the mirror.

If the general semiconductor laser diode 24 that oscillates in single mode is configured to form return light by the above-described configuration, the emission spectrum of the semiconductor laser diode 24 is as an emission spectrum (b2) illustrated in Fig. 4. That is, by forming return light, the spectrum becomes discretely spread. The spectral width at the time varies depending on the above-described angle θ. That is, by adjusting the angle θ, an arbitrary spectral width can be formed.

Furthermore, as described above, in the semiconductor laser diode that forms emission of such a discretely spread spectral distribution, when an alternating-current component of a low frequency of about 50 kHz to 300 kHz is further superimposed on the drive current, respective peak widths of discretely existing peaks are increased, and the emission spectrum becomes continuously spread as the emission spectrum (c) illustrated in Fig. 4.

According to this modification example, neither a complex circuit configuration nor an expensive component for obtaining a high-frequency alternating-current signal is required; therefore, it is possible to adopt a simpler circuit configuration and inexpensively configure a device.

### <4-3. Modification example of configuration of holographic observation device>

The holographic observation device in the above-described embodiment is an in-line holographic observation device; however, an off-line holographic observation device can also obtain an observation image with the influence of object(s) other than an observation object reduced by using a pseudo-coherent light beam with a coherence length depending on the size of the observation object, etc., as in the above-described embodiment.

Fig. 10 illustrates a configuration of a main part of an off-axis holographic observation device 1a that is a modification example. The light source unit 2, the culture plate 3, the image sensor 4, the control unit 5, the input unit 6, and the display unit 7 are assigned the same reference numeral because they are the same as those in the above-described embodiment, and description thereof is omitted. In this holographic observation device 1a, a pseudo-coherent light beam with a predetermined spectral width and predetermined spectral intensity to have a predetermined coherence length emitted from the light source unit 2 is split into a measurement light beam to be cast on cells by a first half mirror 41 and a reference light beam that is not cast on the cells. The measurement light beam reflected by the first half mirror 41 is reflected by a first mirror 42, and then is cast on the cells on the culture plate 3. The reference light beam transmitted through the first half mirror 41 is reflected by a second mirror 45. The measurement light beam transmitted through the cells and the reference light beam reflected by the second mirror 45 are synthesized by a second half mirror 44 and interfere with each other, and are measured by the image sensor 4. The off-axis holographic observation device 1a in Fig. 10 uses transmitted light; however, the present invention can also be applied to those using reflected light.

### <4-4. Modification example of light source unit 2>

Furthermore, in the above-described embodiment, a pseudo-coherent light beam is obtained by superimposing an alternating-current signal on a drive current of the semiconductor laser diode 24, thereby shortening the coherence length of the laser beam; instead of this, a superluminescent diode (SLD) and a light-emitting diode (LED) that generate light with a predetermined spectral width and a shorter coherence length than a semiconductor laser diode can be used. In this case, effects similar to the above-described embodiment can be obtained by using an SLD or an LED that has an appropriate coherence length depending on respective sizes and optical characteristics of an observation object and a non-observation object located on a light path.

Moreover, in the above-described embodiment, the light source unit 2 including only one semiconductor laser diode 24 and the corresponding drive current supply unit 20 is used; however, a light source including a plurality of semiconductor laser diodes that differ in the oscillation wavelength and respective drive units that drive the semiconductor laser diodes or a plurality of SLDs and/or LEDs that differ in the oscillation wavelength can also be used.

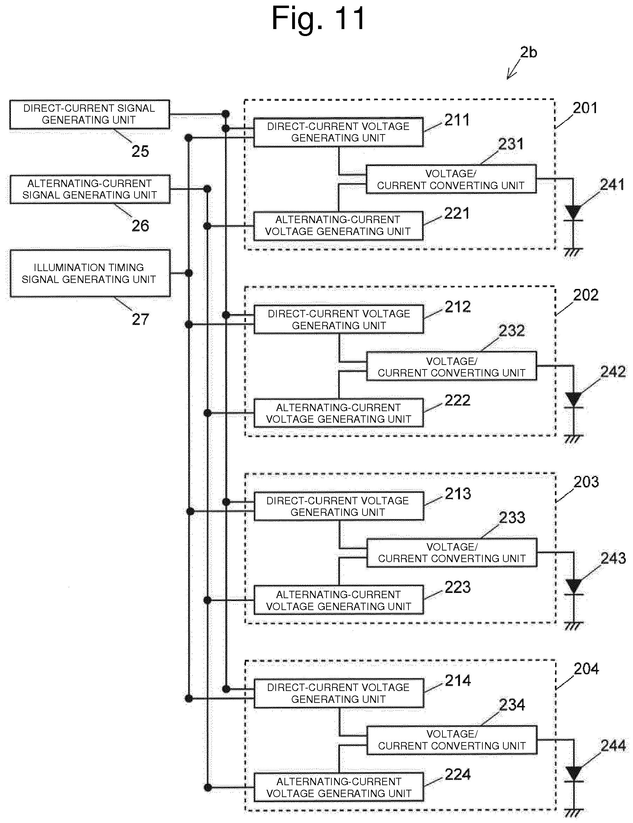

Fig. 11 illustrates a configuration of a light source unit 2b in a case of using a plurality of semiconductor laser diodes that differ in the oscillation wavelength. This light source unit 2b includes four types of semiconductor laser diodes 241 to 244 that emit light of a different wavelength from one another and drive current supply units 201 to 204 that supply a drive current to the semiconductor laser diodes 241 to 244, respectively. Furthermore, the drive current supply units 201 to 204 include direct-current voltage generating units 211 to 214 that generate a direct-current voltage, alternating-current voltage generating units 221 to 224 that generate an alternating-current voltage and superimpose the alternating-current voltage on the direct-current voltage, and voltage/current converting units 231 to 234, respectively. The light source unit 2b further includes a direct-current signal generating unit 25 that generates respective direct-current signals to be transmitted to the direct-current voltage generating units 211 to 214, an alternating-current signal generating unit 26 that generates respective alternating-current signals to be supplied to the alternating-current voltage generating units 221 to 224, and an illumination timing signal generating unit 27 that generates respective timing signals to be supplied to the direct-current voltage generating units 211 to 214.

In this light source unit 2b, the (average) intensity of respective pseudo-coherent light beams emitted from the semiconductor laser diodes 241 to 244 is controlled depending on the magnitude of respective direct-current signals to be transmitted to the direct-current voltage generating units 211 to 214 from the direct-current signal generating unit 25. Furthermore, respective coherence lengths of the pseudo-coherent light beams emitted from the semiconductor laser diodes 241 to 244 are controlled according to the frequency and amplitude of respective alternating-current signals to be transmitted to the alternating-current voltage generating units 212 to 224 from the alternating-current signal generating unit 26. As described above, the frequency of an alternating-current signal is set to be a frequency sufficiently higher (for example, a frequency that is about 1000 times higher) than a readout frequency of the image sensor, and the coherence length is set to be an appropriate length (for example, hundreds of micrometers) depending on the size and optical characteristics of an observation object.

The illumination timing signal generating unit 27 transmits respective timing signals to the semiconductor laser diodes 241 to 244 in sequence. When the timing signals are transmitted to the direct-current voltage generating units 211 to 214, the drive current supply units 201 to 204 superimpose alternating-current signals generated by the alternating-current voltage generating units 221 to 224 on direct-current signals generated by the direct-current voltage generating units 211 to 214 and transmit the superimposed signals to the voltage/current converting units 231 to 234, and drive currents are supplied to the semiconductor laser diodes 241 to 244. Accordingly, pseudo-coherent light beams of different wavelengths are sequentially cast on an observation object, and respective holographic images of the observation object formed of the pseudo-coherent light beams of the different wavelengths are obtained.

An aspect of interference of a pseudo-coherent light beam cast on an observation object differs depending on the wavelength of the light beam. Therefore, in a case where four types of pseudo-coherent light beams of different wavelengths are cast on an observation object as described above, four types of holographic images that are different depending on the wavelength are obtained. An image of the observation object is reconstructed by using the four types of holographic images obtained in this way, thereby the image of the observation object can be obtained with higher resolution as compared with the case of using only one type of light beam of a wavelength.

### REFERENCE SIGNS LIST

1, 1a... Holographic Observation Device
2, 2a, 2b... Light Source Unit
   20, 201 to 204... Drive Current Supply Unit
   21, 211 to 214... Direct-Current Voltage Generating Unit
   22, 221 to 224... Alternating-Current Voltage Generating Unit
   23, 231 to 234... Voltage/Current Converting Unit
   24, 241 to 244... Semiconductor Laser Diode
   25... Direct-Current Signal Generating Unit
   26... Alternating-Current Signal Generating Unit
   27... Illumination Timing Signal Generating Unit
3... Culture Plate
4... Image Sensor
5... Control Unit
   50... Storage Unit
   51... Light Source Control Unit
   52... Arithmetic Processing Unit
6... Input Unit
7... Display Unit
41... First Half Mirror
42... First Mirror
44... Second Half Mirror
45... Second Mirror
81... Collimating Lens
82... Focusing Lens
83... Ferrule
   830... Reflecting Surface
84... Optical Fiber

## Claims

1. A holographic observation method comprising:
casting a light beam generated by driving a semiconductor laser light source with an electric current with an alternating-current component superimposed to an observation object;
forming a hologram by causing a light beam transmitted through or reflected by the observation object to interfere with a reference light beam; and
obtaining information on the observation object by performing image processing on the hologram.

2. A holographic observation method comprising:
casting a light beam having a predetermined spectral width and predetermined spectral intensity to have predetermined coherency to an observation object;
forming a hologram by causing a light beam transmitted through or reflected by the observation object to interfere with a reference light beam; and
obtaining information on the observation object by performing image processing on the hologram.

3. A holographic observation device comprising:
a) a semiconductor laser light source;
b) a current source that supplies a drive current with an alternating-current component superimposed to the semiconductor laser light source;
c) an exposure optical system that causes a light beam emitted from the semiconductor laser light source driven with the drive current to be transmitted through or reflected by an observation object and interfere with light transmitted through or reflected at a different spot of the observation object; and
d) an image sensor that acquires an interference image of the light beam transmitted through or reflected by the observation object.

4. A holographic observation device comprising:
a) a semiconductor laser light source;
b) a current source that supplies an electric current with an alternating-current component superimposed to the semiconductor laser light source;
c) an exposure optical system that splits a light beam emitted from the semiconductor laser light source driven with the drive current into two light beams, and causes one of the two light beams to be transmitted through or reflected by an observation object; and
c) an image sensor that acquires an interference image of the light beam transmitted through or reflected by the observation object and a light beam that is the other of the two light beams and is neither transmitted through nor reflected by the observation object.

5. The holographic observation device according to claim 3 or 4, wherein a frequency of the alternating-current component is 50 kHz to 300 kHz.

6. The holographic observation device according to claim 5, wherein a frequency component of 100 MHz to 500 MHz is further superimposed on the alternating-current component.

7. The holographic observation device according to claim 5, further comprising a return light forming unit that returns a portion of the light beam emitted from the semiconductor laser light source to the semiconductor laser light source.

8. The holographic observation device according to claim 7, wherein the return light forming unit includes a reflecting member that has a reflecting surface that reflects at least a portion of incident light and is arranged to be on an optical axis of the light beam emitted from the semiconductor laser light source and in an orientation that allows a normal line of the reflecting surface to be inconsistent with the optical axis.

9. The holographic observation device according to claim 3 or 4, wherein a frequency of the alternating-current component is higher than a signal readout frequency of the image sensor.

10. The holographic observation device according to claim 3 or 4, wherein a frequency of the alternating-current component is 100 MHz to 500 MHz.

11. A holographic observation device comprising:
a) a light source that emits a light beam having a predetermined spectral width and predetermined spectral intensity to have predetermined coherency;
b) an exposure optical system that causes the light beam to be transmitted through or reflected by an observation object and interfere with light transmitted through or reflected at a different spot of the observation object; and
c) an image sensor that acquires an interference image of the light beam transmitted through or reflected by the observation object.

12. A holographic observation device comprising:
a) a light source that emits a light beam having a predetermined spectral width and predetermined spectral intensity to have predetermined coherency;
b) an exposure optical system that splits the light beam into two light beams, and causes one of the two light beams to be transmitted through or reflected by an observation object; and
c) an image sensor that acquires an interference image of the light beam transmitted through or reflected by the observation object and a light beam that is the other of the two light beams and is neither transmitted through nor reflected by the observation object.

13. A cell image observation device comprising the holographic observation device according to any of claims 3, 4, 11, and 12.

14. A light source unit comprising:
a semiconductor laser light source; and
a return light forming unit that returns a portion of a light beam emitted from the semiconductor laser light source to the semiconductor laser light source,
wherein the return light forming unit includes a reflecting member that has a reflecting surface that reflects at least a portion of incident light and is arranged to be on an optical axis of the light beam emitted from the semiconductor laser light source and in an orientation that allows a normal line of the reflecting surface to be inconsistent with the optical axis.
